Europäisches Patentamt

European Patent Office

Office européen des brevets

(19)

(11) Publication number: **0 196 883 B1**

(12) **EUROPEAN PATENT SPECIFICATION**

(45) Date of publication of patent specification: **03.06.92**  (51) Int. Cl.⁵: **H03H 11/12**

(21) Application number: **86302276.0**

(22) Date of filing: **26.03.86**

(54) **Active filter circuits.**

(30) Priority: **29.03.85 JP 65872/85**

(43) Date of publication of application:
**08.10.86 Bulletin 86/41**

(45) Publication of the grant of the patent:
**03.06.92 Bulletin 92/23**

(84) Designated Contracting States:
**AT DE FR GB NL**

(56) References cited:
**FR-A- 2 437 735**
**FR-A- 2 438 938**

**IEEE JOURNAL OF SOLID-STATE CIRCUITS,
vol. SC-3, no. 4, December 1968, pages
353-365; B. GILBERT: "A new wide-band am-
plifier technique"**

(73) Proprietor: **SONY CORPORATION
7-35 Kitashinagawa 6-Chome Shinagawa-ku
Tokyo 141(JP)**

(72) Inventor: **Fukuda, Tokuya c/o Sony Corpora-
tion
Patents Division 6-7-35 Kitashinagawa
Shinagawa-ku Tokyo 141(JP)**
Inventor: **Ishizuka, Shigeki c/o Sony Corpora-
tion
Patents Division 6-7-35 Kitashinagawa
Shinagawa-ku Tokyo 141(JP)**
Inventor: **Yamashita, Noriyuki c/o Sony Cor-
poration
Patents Division 6-7-35 Kitashinagawa
Shinagawa-ku Tokyo 141(JP)**

(74) Representative: **Cotter, Ivan John et al
D. YOUNG & CO. 10 Staple Inn
London WC1V 7RD(GB)**

Rank Xerox (UK) Business Services

EP 0 196 883 B1

## Description

This invention relates to active filter circuits.

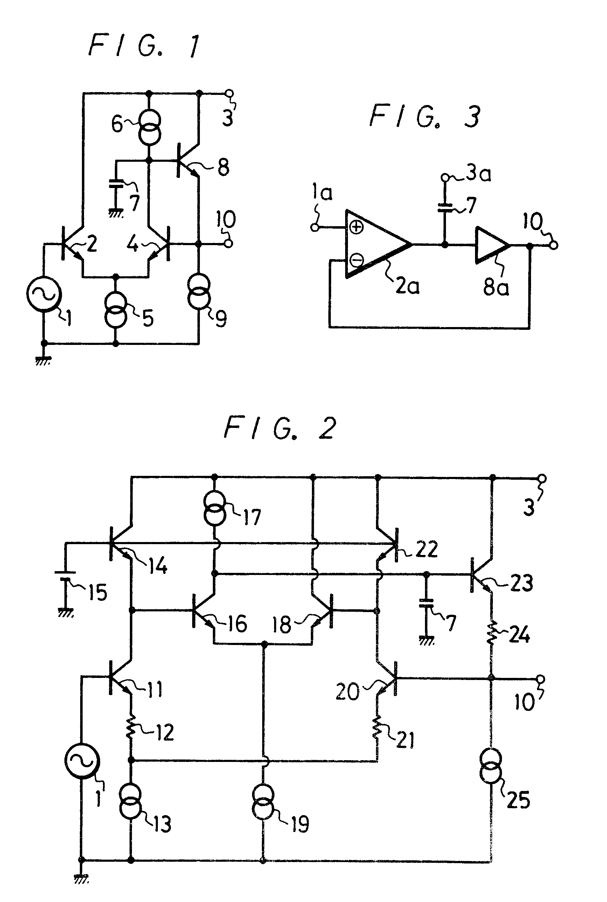

Previously proposed active filter circuits developed for use with a semiconductor integrated circuit which is used to process a television signal and a video signal are shown in Figures 1 and 2 of the accompanying drawings.

Figure 1 shows an example of a previously proposed low pass filter. In Figure 1, one side of an input signal source 1 is connected to the base of an npn transistor 2 while the other side of the input signal source 1 is grounded. The collector of the transistor 2 is connected to a voltage source terminal 3 to which a positive dc voltage is applied. The emitter of the transistor 2 is connected to the emitter of an npn transistor 4 and the junction or connection point between the emitters of the transistors 2 and 4 is grounded via a constant current circuit 5 through which a predetermined current I flows. The collector of the transistor 4 is connected to the voltage source terminal 3 via a constant current source circuit 6. Also, the collector of the transistor 4 is grounded via a capacitor 7 having a capacitance C which forms a load. The collector of the transistor 4 is further connected to the base of an npn transistor 8 which forms an emitter-follower circuit of a feedback loop. The collector of the transistor 8 is connected to the voltage source terminal 3 and the emitter of the transistor 8 is grounded via a constant current circuit 9. The emitter of the transistor 8 is further connected to the base of the transistor 4 and an output terminal 10 is led out from the emitter of the transistor 8.

In principle, the active filter circuit shown in Figure 1 forms a mutual conductance (Gm) feedback type primary filter circuit as shown in Figure 3, and its filter characteristic H ($\omega$) is represented by

$$H(\omega) = \frac{1}{1 + j\omega 2 C r e}$$

where re is the emitter resistance (re = kT/qI) of the transistors 2 and 4 and $\omega$ is the angular frequency.

The Gm feedback type primary filter circuit shown in Figure 3 will be described briefly. If the level of an input signal supplied to an input terminal 1a is taken as L, the amplification factor of a differential amplifier circuit 2a is taken as (I/r), the dc voltage supplied to a voltage source terminal 3a is taken as H, the capacitance of a capacitor 7 is taken as C and an output level generated at an output terminal 10 is taken as X, the following relationships are established:

$$(L - X) \frac{1}{r} = j\omega C (X - H) ; \text{ and}$$

$$X = \frac{L + j\omega C r H}{1 + j\omega C r} .$$

Figure 2 shows another example of a previously proposed primary low pass filter. The primary low pass filter of Figure 2 employs a so-called Gilbert circuit.

Referring to Figure 2, one side of an input signal source 1 is connected to the base of an npn transistor 11 while the other end of the source 1 is grounded. The emitter of the transistor 11 is grounded via a series circuit formed of a resistor 12 having a resistance R and a constant current circuit 13 having a current I. The collector of the transistor 11 is connected to the emitter of an npn transistor 14, the collector of which is connected to a voltage source terminal 3. The base of the transistor 14 is grounded via a battery 15. The collector of the transistor 11 is connected to the base of an npn transistor 16, the collector of which is connected to the voltage source terminal 3 via a constant current circuit 17. The emitter of the transistor 16 is connected to the emitter of an npn transistor 18, and the junction between the emitters of the transistors 16 and 18 is grounded via a constant current circuit 19 having a constant current I. The collector of the transistor 18 is connected to the voltage source terminal 3. The base of the transistor 18 is connected to the collector of an npn transistor 20, the emitter of which is connected through a resistor 21 having a resistance R to the junction between the resistor 12 and the constant current circuit 13. The collector of the transistor 20 is connected to the emitter of an npn transistor 22, the collector of which is connected to the voltage source terminal 3. The base of the transistor 22 is connected to the base of the transistor 14. The collector of the transistor 16 is grounded via a capacitor 7 having a capacitance C which forms a load. Also, the collector of the transistor 16 is connected to the base of an npn transistor 23 which forms an emitter-follower circuit of a feedback loop. The collector of the transistor 23 is connected to the voltage source terminal 3 and the emitter of the transistor 23 is grounded via a series circuit formed of a resistor 24 and a constant current circuit 25. The junction between the resistor 24 and the constant current circuit 25 is connected to the base of the transistor 20 and an output terminal 10 is led out from the junction between the resistor 24 and the constant current circuit 25.

In principle, the active filter circuit shown in Figure 2 forms a mutual conductance (Gm) feedback type primary filter circuit as shown in Figure 3 and its filter characteristic H(ω) is represented by

$$H(\omega) \;=\; \frac{1}{1 \,+\, j\omega\, 2C(R \,+\, re)} \quad .$$

Although the number of circuit elements constituting the active filter circuit shown in Figure 1 is small, the dynamic range of this active filter circuit is given as Ire and the emitter resistance re of the transistor is very small, whereby the dynamic range of this active filter circuit is significantly narrow.

On the other hand, since the dynamic range of the active filter circuit shown in Figure 2 is given as I(R + re), if the respective resistance values R of the resistors 12 and 21 are increased, this dynamic range can be widened. However, since an active filter circuit such as that shown in Figure 2 requires many circuit elements, when this active filter circuit is used for a large scale integration (LSI) circuit which uses a number of active filter circuits, the number of circuit elements used therein is increased more.

UK Patent Application Publication No. GB-A-2 033 182 (corresponding to French Patent Application Publication No. FR-A-2 437 735) discloses an active filter circuit comprising emitter-coupled first and second transistors, a reactance circuit connected to a collector electrode of the second transistor, an output terminal connected to an electrode of the second transistor and a reference potential terminal. According to different arrangements disclosed in GB-A-2 033 182, the input signal may be supplied to a base electrode of the first transistor or may be supplied to the collector electrode of the second transistor by way of the reactance circuit.

According to a first aspect of the present invention there is provided an active filter circuit comprising:
emitter-coupled first and second transistors;
a reactance circuit connected to a collector electrode of the second transistor;
an output terminal connected to an electrode of the second transistor; and
a reference potential terminal;
characterised in that:
the filter circuit includes emitter-coupled third and fourth transistors, base and collector electrodes of the third transistor being connected to a base electrode of the first transistor, base and collector electrodes of the fourth transistor being connected to a base electrode of the second transistor, the base electrode of the first transistor being connected to an emitter electrode of a fifth transistor by way of a first resistor, the base electrode of the second transistor being connected to an emitter electrode of a sixth transistor by way of a second resistor, and collector electrodes of the fifth and sixth transistors being connected to the reference potential terminal;
the filter circuit is so constructed that an input signal can be supplied to a base electrode of the fifth transistor; and
the output terminal is connected to the collector electrode of the second transistor and to a base electrode of the sixth transistor.

According to a second aspect of the present invention there is provided an active filter circuit comprising:
emitter-coupled first and second transistors;
a reactance circuit connected to a collector electrode of the second transistor;
the filter circuit being so constructed that an input signal can be supplied to the collector electrode of the second transistor by way of the reactance circuit;
an output terminal connected to an electrode of the second transistor; and
a reference potential terminal;
characterised in that:
the filter circuit includes emitter-coupled third and fourth transistors, base and collector electrodes of the third transistor being connected to a base electrode of the first transistor, base and collector electrodes of the fourth transistor being connected to a base electrode of the second transistor, the base electrode of the first transistor being connected to an emitter electrode of a fifth transistor by way of a first resistor, the base electrode of the second transistor being connected to an emitter electrode of a sixth transistor by way of a second resistor, and collector electrodes of the fifth and sixth transistors being connected to the reference potential terminal; and

the output terminal is connected to the collector electrode of the second transistor and to a base electrode of the sixth transistor.

According to a third aspect of the invention there is provided an active filter circuit according to the above-recited first aspect, modified in that:

the active filter circuit comprises first and second sub-circuits, the first sub-circuit comprising first to sixth transistors, first and second resistors and a reactance circuit connected together and connected to the reference potential terminal as set forth in the first aspect, and the second sub-circuit comprising first to sixth transistors, first and second resistors and a reactance circuit connected together and connected to the reference potential terminal as set forth in the first aspect;

the filter circuit is so constructed that an input signal can be supplied to the base electrode of the fifth transistor of the first sub-circuit;

the collector electrode of the second transistor of the first sub-circuit is connected to the base electrode of the fifth transistor of the second sub-circuit; and

the output terminal is connected to the collector electrode of the second transistor of the second sub-circuit and to the base electrodes of the sixth transistors of the first and second sub-circuits.

Preferred embodiments of the invention described hereinbelow can be constructed so as to provide an active filter circuit having the following advantages:

its dynamic range is very wide;

the number of circuit elements used therein can be reduced;

if the active filter circuit is incorporated in or formed as a semiconductor integrated circuit or the like, the active filter circuit does not depend on an internal resistance of the semiconductor integrated circuit;

the active filter circuit can have a good temperature characteristic when formed as a semiconductor integrated circuit; and

the active filter circuit can have a uniform filter characteristic and can be of excellent phase characteristic at high frequency range and have an excellent frequency characteristic.

The invention will now be further described, by way of illustrative and non-limiting example, with reference to the accompanying drawings, in which like references designate like elements and parts throughout, and in which:

Figures 1 and 2 are circuit diagrams showing examples of respective previously proposed active filter circuits;

Figure 3 is a diagram illustrating in principle a mutual conductance (Gm) feedback type primary filter circuit;

Figure 4 is a circuit diagram of an active filter circuit embodying this invention;

Figure 5 is a circuit diagram of another active filter circuit embodying this invention, which operates as a high pass filter; and

Figure 6 is a circuit diagram of a further active filter circuit embodying this invention, which operates as a secondary low pass filter.

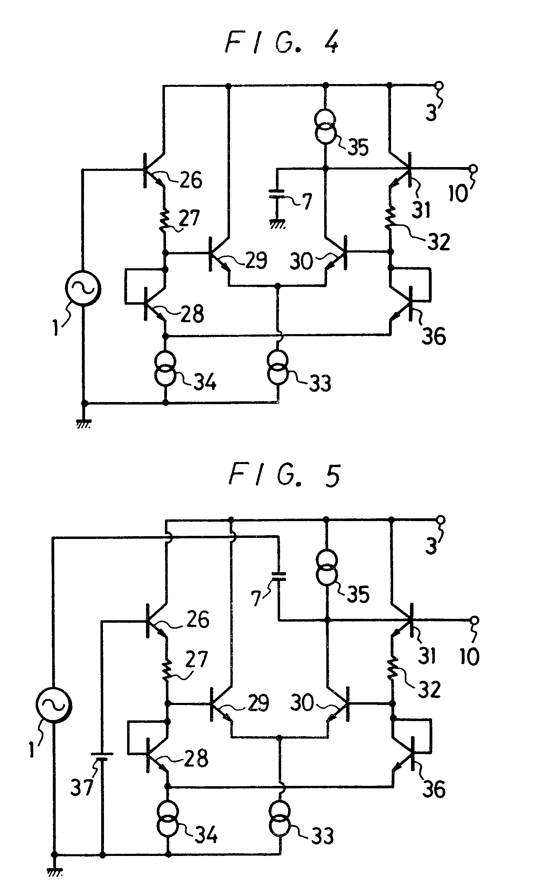

An active filter circuit embodying this invention will now be described with reference to Figure 4. In Figure 4, parts corresponding to like parts of Figures 1 and 2 are designated by the same references and their detailed description will not be repeated.

According to the embodiment shown in Figure 4, one end of the input signal source 1 is connected to the base of an npn transistor 26 while the other end of the signal source 1 is grounded. The collector of the transistor 26 is connected to the voltage source terminal 3, while the emitter of the transistor 26 is connected through a resistor 27 having a resistance value $R_1$ to a junction between the base and collector of an npn transistor 28 (which forms a diode) and is also connected to the base of an npn transistor 29. The transistors 28 and 29 constitute a differential amplifier circuit. The emitter of the transistor 28 is grounded via a constant current circuit 34 having a constant current $I_1$. The collector of the transistor 29 is connected to the voltage source terminal 3 and the emitter of the transistor 29 is connected to the emitter of an npn transistor 30 which forms, together with the transistor 29, a differential amplifier circuit. The junction between the emitters of the transistors 29 and 30 is grounded via a constant current circuit 33 having a constant current $I_2$. The collector of the transistor 30 is connected to the voltage source terminal 3 via a constant current source 35, while the collector of the transistor 30 is grounded via the capacitor 7 which forms a reactance circuit serving as a load. The output terminal 10 is led out from the collector of the transistor 30, which collector is connected to the base of an npn transistor 31. The collector of the transistor

4

31 is connected to the voltage source terminal 3 and the emitter of this transistor 31 is connected through a resistor 32 having a resistance value $R_1$ to a junction between the base and collector of an npn transistor 36 (which forms a diode) and to the base of the transistor 30. The emitter of the transistor 36 is connected to the emitter of the transistor 28.

The active filter circuit shown in Figure 4 also forms a Gm feedback type primary filter circuit having the construction shown in principle in Figure 3. In Figure 4, the conditions that Vin = L, Vout = X and $l/r$ = $l/(2R_1 + 4re)$ are satisfied. When $I_1 = I_2$, its filter characteristic $H(\omega)$ is given as

$$H(\omega) = \frac{Vout}{Vin} = \frac{1}{1 + j\omega C (2R_1 + 4re)} \quad .$$

Thus, the active filter circuit of Figure 4 is a low pass filter circuit in which the condition

$$\omega c = 1/C (2R_1 + 4re)$$

is satisfied.

Also, in the active filter circuit shown in Figure 4, if the current $I_1$ is taken as a current which is determined by the internal resistance of a semiconductor integrated circuit and the current $I_2$ is taken as a current which is determined by a resistor externally connected thereto, the following relation is satisfied

$$\frac{1}{r} = \frac{1}{I_1 (2R_1 + 4re)} \quad .$$

Thus, its filter characteristic $H(\omega)$ becomes

$$H(\omega) = \frac{1}{1 + j\omega C \dfrac{\dfrac{1}{I_1 (2R_1 + 4re)}}{I_2}}$$

$$= \frac{1}{1 + j\omega C \dfrac{\dfrac{Vref}{R_1} (2R_1 + 4re)}{I_2}} \quad .$$

Consequently, it is possible to realise an active filter circuit which does not depend on the internal resistance of the semiconductor integrated circuit. Accordingly, when this active filter circuit is formed in an semiconductor integrated circuit, it is possible to obtain an active filter circuit which has an excellent temperature characteristic and whose filter characteristic is not scattered.

The dynamic range of the active filter circuit according to the embodiment of Figure 4 is determined by $I_2 (2R_1 + 4re)$ so that this dynamic range can be widened similarly to the previously proposed example of Figure 2. Further, according to the embodiment of Figure 4, since the emitter-follower circuit is not required in the feedback circuit, it is possible to reduce the number of circuit elements. For example, it is possible to reduce the number of circuit elements by 20% as compared with the example of Figure 2. Therefore, this embodiment of the invention is particularly advantageous when used in an LSI circuit which employs a large number of active filter circuit elements. Furthermore, since there is no emitter-follower circuit in the feedback circuit, the phase characteristic of the active filter circuit is never affected so that the active filter circuit of this embodiment has an excellent phase characteristic in the high frequency band, thus presenting a satisfactory frequency characteristic.

Figure 5 shows another active filter circuit embodying the present invention which operates as a high pass filter circuit. In Figure 5, parts corresponding to like parts of Figure 4 are designated by the same references and will not be described again.

According to the embodiment shown in Figure 5, one end of the input signal source 1 is connected through the capacitor 7 forming a reactance circuit to the collector of the transistor 30 and the other end of the signal source 1 is grounded. The base of the transistor 26 is grounded via a battery 37 which generates a predetermined dc voltage. The circuit otherwise is formed in the same way as in Figure 4.

In principle, the active filter circuit shown in Figure 5 forms a Gm feedback type primary filter circuit as shown in Figure 3 and also forms a high pass filter circuit. It will easily be understood that the embodiment shown in Figure 5 can achieve the same action and effect as that of Figure 4.

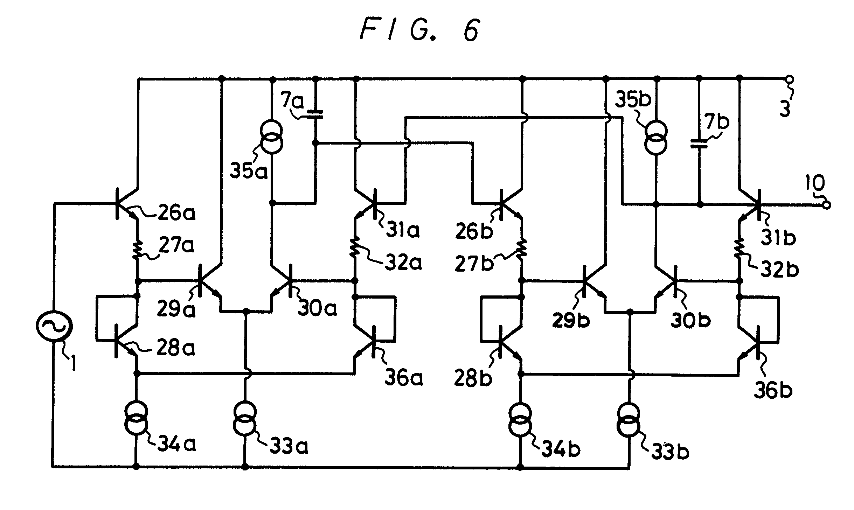

Figure 6 shows another active filter circuit embodying the present invention which operates as a secondary low pass filter. In Figure 6, parts corresponding to like parts of Figure 4 are designated by the same references suffixed with a and b. From Figure 6, it will easily be understood that the active filter circuit according to this embodiment can achieve the same action and effect as that of Figure 4.

According to the embodiments of the present invention described above, it is possible to obtain an active filter circuit having a wide dynamic range and in which the number of circuit elements can be reduced. The embodiments of the invention become particularly advantageous when applied to an LSI circuit which employs a large number of active filter circuits.

Further, embodiments of the present invention make it possible to realise an active filter circuit which does not depend on the internal resistance of a semiconductor integrated circuit. Accordingly, when the active filter circuit is formed into a semiconductor integrated circuit, it is possible to obtain an active filter circuit which has an excellent temperature characteristic and whose filter characteristic can be prevented from being scattered.

Furthermore, according to the embodiments of the invention as set forth above, since there is no emitter-follower circuit in the feedback circuit it is possible to obtain an active filter circuit which can have a good phase characteristic in the high frequency range and which can have a good frequency characteristic.

**Claims**

1. An active filter circuit comprising:
   emitter-coupled first and second transistors (29, 30);
   a reactance circuit (7) connected to a collector electrode of the second transistor (30);
   an output terminal (10) connected to an electrode of the second transistor (30); and
   a reference potential terminal (3);
   characterised in that:
   the filter circuit includes emitter-coupled third and fourth transistors (28, 36), base and collector electrodes of the third transistor (28) being connected to a base electrode of the first transistor (29), base and collector electrodes of the fourth transistor (36) being connected to a base electrode of the second transistor (30), the base electrode of the first transistor (29) being connected to an emitter electrode of a fifth transistor (26) by way of a first resistor (27), the base electrode of the second transistor (30) being connected to an emitter electrode of a sixth transistor (31) by way of a second resistor (32), and collector electrodes of the fifth and sixth transistors (26, 31) being connected to the reference potential terminal (3);
   the filter circuit is so constructed that an input signal can be supplied to a base electrode of the fifth transistor (26); and
   the output terminal (10) is connected to the collector electrode of the second transistor (30) and to a base electrode of the sixth transistor (31).

2. An active filter circuit comprising:
   emitter-coupled first and second transistors (29, 30);
   a reactance circuit (7) connected to a collector electrode of the second transistor (30);
   the filter circuit being so constructed that an input signal can be supplied to the collector electrode of the second transistor (30) by way of the reactance circuit (7);
   an output terminal (10) connected to an electrode of the second transistor (30); and
   a reference potential terminal (3);
   characterised in that:
   the filter circuit includes emitter-coupled third and fourth transistors (28, 36), base and collector electrodes of the third transistor (28) being connected to a base electrode of the first transistor (29),

EP 0 196 883 B1

base and collector electrodes of the fourth transistor (36) being connected to a base electrode of the second transistor (30), the base electrode of the first transistor (29) being connected to an emitter electrode of a fifth transistor (26) by way of a first resistor (27), the base electrode of the second transistor (30) being connected to an emitter electrode of a sixth transistor (31) by way of a second resistor (32), and collector electrodes of the fifth and sixth transistors (26, 31) being connected to the reference potential terminal (3); and

the output terminal (10) is connected to the collector electrode of the second transistor (30) and to a base electrode of the sixth transistor (31).

3. An active filter circuit according to claim 1 or claim 2, wherein the reactance circuit (7) comprises a capacitor.

4. An active filter circuit according to claim 1, modified in that:

the active filter circuit comprises first and second sub-circuits, the first sub-circuit comprising first to sixth transistors (29a, 30a, 28a, 36a, 26a, 31a), first and second resistors (27a, 32a) and a reactance circuit (7a) connected together and connected to the reference potential terminal (3) as set forth in claim 1, and the second sub-circuit comprising first to sixth transistors (29b, 30b, 28b, 36b, 26b, 31b), first and second resistors (27b, 32b) and a reactance circuit (7b) connected together and connected to the reference potential terminal (3) as set forth in claim 1;

the filter circuit is so constructed that an input signal can be supplied to the base electrode of the fifth transistor (26a) of the first sub-circuit;

the collector electrode of the second transistor (30a) of the first sub-circuit is connected to the base electrode of the fifth transistor (26b) of the second sub-circuit; and

the output terminal (10) is connected to the collector electrode of the second transistor (30b) of the second sub-circuit and to the base electrodes of the sixth transistors (31a, 31b) of the first and second sub-circuits.

5. An active filter circuit according to claim 4, wherein the reactance circuit (7a, 7b) of each of the first and second sub-circuits comprises a capacitor.

**Revendications**

1. Circuit à filtre actif, comprenant :

un premier et un second transistor (29, 30) couplés par les émetteurs,

un circuit à réactance (7) connecté à une électrode de collecteur du second transistor (30),

une borne de sortie (10) connectée à une électrode du second transistor (30), et

une borne (3) d'un potentiel de référence,

caractérisé en ce que

le circuit à filtre comprend un troisième et un quatrième transistor (28, 36) couplés par les émetteurs, les électrodes de base et de collecteur du troisième transistor (28) étant connectées à une électrode de base du premier transistor (29), les électrodes de base et de collecteur du quatrième transistor (36) étant connectées à une électrode de base du second transistor (30), l'électrode de base du premier transistor (29) étant connectée à une électrode d'émetteur d'un cinquième transistor (26) par l'intermédiaire d'une première résistance (27), l'électrode de base du second transistor (30) étant connectée à une électrode d'émetteur d'un sixième transistor (31) par l'intermédiaire d'une seconde résistance (32), et les électrodes de collecteur du cinquième et du sixième transistor (26, 31) étant connectées à la borne (3) d'un potentiel de référence,

le circuit à filtre ayant une construction telle qu'un signal d'entrée peut être transmis à une électrode de base du cinquième transistor (26), et

la borne de sortie (10) est connectée à l'électrode de collecteur du second transistor (30) et à une électrode de base du sixième transistor (31).

2. Circuit à filtre actif, comprenant :

un premier et un second transistor (29, 30) couplés par les émetteurs,

un circuit à réactance (7) connecté à une électrode de collecteur du second transistor (30),

le circuit à filtre ayant une construction telle qu'un signal d'entrée peut être transmis à l'électrode de collecteur du second transistor (30) par le circuit à réactance (7),

une borne de sortie (10) connectée à une électrode du second transistor (30), et

7

une borne (3) d'un potentiel de référence,

caractérisé en ce que

le circuit à filtre comprend un troisième et un quatrième transistor (28, 36) couplés par les émetteurs, les électrodes de base et de collecteur du troisième transistor (28) étant connectées à une électrode de base du premier transistor (29), les électrodes de base et de collecteur du quatrième transistor (36) étant connectées à une électrode de base du second transistor (30), l'électrode de base du premier transistor (29) étant connectée à une électrode d'émetteur d'un cinquième transistor (26) par l'intermédiaire d'une première résistance (27), l'électrode de base du second transistor (30) étant connectée à une électrode d'émetteur d'un sixième transistor (31) par une seconde résistance (32), et les électrodes de collecteur du cinquième et du sixième transistor (26, 31) étant connectées à la borne (3) d'un potentiel de référence, et

la borne de sortie (10) est connectée à l'électrode de collecteur du second transistor (30) et à une électrode de base du sixième transistor (31).

3. Circuit à filtre actif selon la revendication 1 ou 2, dans lequel le circuit à réactance (7) comporte un condensateur.

4. Circuit à filtre actif selon la revendication 1, modifié en ce que

le circuit à filtre actif comprend un premier et un second circuit auxiliaire, le premier circuit auxiliaire comprenant des transistors (29a, 30a, 28a, 36a, 26a, 31a), d'un premier au sixième, une première et une seconde résistance (27a, 32a) et un circuit à réactance (7a) qui sont connectés mutuellement et qui sont connectés à la borne (3) d'un potentiel de référence tel que défini dans la revendication 1, et le second circuit auxiliaire comprend des transistors (29b, 30b, 28b, 36b, 26b, 31b), d'un premier au sixième, une première et une seconde résistance (24b, 32b) et un circuit à réactance (7b) qui sont connectés mutuellement et qui sont connectés à la borne (3) d'un potentiel de référence tel que défini dans la revendication 1,

le circuit à filtre a une construction telle qu'un signal d'entrée peut être transmis à l'électrode de base du cinquième transistor (26a) du premier circuit auxiliaire,

l'électrode de collecteur du second transistor (30a) du premier circuit auxiliaire est connectée à l'électrode de base du cinquième transistor (26b) du second circuit auxiliaire, et

la borne de sortie (10) est connectée à l'électrode de collecteur du second transistor (30b) du second circuit auxiliaire et aux électrodes de base des sixièmes transistors (31a, 31b) du premier et du second circuit auxiliaire.

5. Circuit à filtre actif selon la revendication 4, dans lequel le circuit à réactance (7a, 7b) de chacun des premier et second circuits auxiliaires comporte un condensateur.

**Patentansprüche**

1. Aktive Filterschaltung

mit einem ersten und einem zweiten Transistor (29, 30), die in Emitterkopplung miteinander verbunden sind,

mit einer mit der Kollektorelektrode des zweiten Transistors (30) verbundenen Reaktanzschaltung (7),

mit einem mit einer Elekrode des zweiten Transistors (30) verbundenen Ausgangsanschluß (10)

sowie mit einem Referenzpotentialanschluß (3),

**dadurch gekennzeichnet,**

daß die Filterschaltung einen dritten und einen vierten Transistor (28, 36) aufweist, die in Emitterkopplung miteinander verbunden sind, wobei die Basiselektrode und die Kollektorelektrode des dritten Transistors (28) mit der Basiselektrode des ersten Transistors (29) verbunden ist, die Basiselektrode und die Kollektorelektrode des vierten Transistors (36) mit der Basiselektrode des zweiten Transistors (30) verbunden ist, die Basiselektrode des ersten Transistors (29) über einen ersten Widerstand (27) mit dem Emitter eines fünften Transistors (26) verbunden ist, die Basiselektrode des zweiten Transistors (30) über einen zweiten Widerstand (32) mit dem Emitter eines sechsten Transistors (31) verbunden ist und die Kollektorelektroden des fünften und sechsten Transistors (26, 31) mit dem Referenzpotentialanschluß verbunden sind,

daß die Filterschaltung so aufgebaut ist, daß der Basiselektrode des fünften Transistors (26) ein Eingangssignal zuführbar ist,

und daß der Ausgangsanschluß (10) mit der Kollektorelektrode des zweiten Transistors (30) und mit der Basiselektrode des sech-sten Transistors (31) verbunden ist.

**2.** Aktive Filterschaltung

mit einem ersten und einem zweiten Transistor (29, 30), die in Emitterkopplung miteinander verbunden sind,

mit einer mit dem Kollektorelektrode des zweiten Transistors (30) verbundenen Reaktanzschaltung (7), wobei die Filterschaltung so aufgebaut ist, daß der Kollektorelektrode des zweiten Transistors (30) über die Reaktanzschaltung (7) ein Eingangssignal zuführbar ist,

mit einem mit einer Elektrode des zweiten Transistors (30) verbundenen Ausgangsanschluß (10) sowie mit einem Referenzpotentialanschluß (3),

**dadurch gekennzeichnet,**

daß die Filterschaltung einen dritten und einen vierten Transistor (28, 36) aufweist, die in Emitterkopplung miteinander verbunden sind, wobei die Basiselektrode und die Kollektorelektrode des dritten Transistors (28) mit der Basiselektrode des ersten Transistors (29) verbunden ist, die Basiselektrode und die Kollektorelektrode des vierten Transistors (36) mit der Basiselektrode des zweiten Transistors (30) verbunden ist, die Basiselektrode des ersten Transistors (29) über einen ersten Widerstand (27) mit dem Emitter eines fünften Transistors (26) verbunden ist, die Basiselektrode des zweiten Transistors (30) über einen zweiten Widerstand (32) mit dem Emitter eines sechsten Transistors (31) verbunden ist und die Kollektoren des fünften und sechsten Transistors (26, 31) mit dem Referenzpotentialanschluß verbunden sind,

und daß der Ausgangsanschluß (10) mit dem Kollektorelektrode des zweiten Transistors (30) und mit der Basiselektrode des sechsten Transistors (31) verbunden ist.

**3.** Aktive Filterschaltung nach Anspruch 1 oder 2, bei der die Reaktanzschaltung (7) einen Kondensator enthält.

**4.** Aktive Filterschaltung nach Anspruch 1, die so modifiziert ist,

daß sie eine erste und eine zweite Subschaltung aufweist, wobei die erste Subschaltung einen ersten bis sechsten Transistor (29a, 30a, 28a, 36a, 26a bzw. 31a), einen ersten und einen zweiten Widerstand (27a, 32a) und eine Reaktanzschaltung (7a) umfaßt, die in der in Anspruch 1 angegebenen Weise miteinander und mit dem Referenzpotentialanschluß verbunden sind, und wobei die zweite Subschaltung einen ersten bis sechsten Transistor (29b, 30b, 28b, 36b, 26b bzw. 31b), einen ersten und einen zweiten Widerstand (27b, 32b) und eine Reaktanzschaltung (7b) umfaßt, die in der in Anspruch 1 angegebenen Weise miteinander und mit dem Referenzpotentialanschluß verbunden sind,

daß die Filterschaltung so aufgebaut ist, daß der Basiselektrode des fünften Transistors (26a) der ersten Subschaltung ein Eingangssignal zuführbar ist,

daß die Kollektorelektrode des zweiten Transistors (30a) der ersten Subschaltung mit der Basiselektrode des fünften Transistors (26b) der zweiten Subschaltung verbunden ist,

und daß der Ausgangsanschluß (10) mit der Kollektorelektrode des zweiten Transistors (30b) der zweiten Subschaltung und mit den Basiselektrodeelektroden der sechsten Transistoren (31a, 31b) der ersten und der zweiten Subschaltung verbunden ist.

**5.** Aktive Filterschaltung nach Anspruch 4, bei der die Reaktanzschaltungen (7a, 7b) sowohl der ersten als auch der zweiten Subschaltung einen Kondensator enthalten.

# FIG. 1

# FIG. 3

# FIG. 2

F I G. 4

F I G. 5

F I G. 6

EP 0 196 883 B1